# EUROPÄISCHE PATENTSCHRIFT

(11) **EP 1 284 006 B1**
(45) Veröffentlichungstag und Bekanntmachung des Hinweises auf die Patenterteilung: **20.10.2004**
(21) Anmeldenummer: 01940220.5
(22) Anmeldetag: 09.05.2001
(51) Int. Cl.: H01H 9/16, H03K 17/18

(54) **BESCHALTUNG FÜR EINE SCHALTSTRECKE**
PROTECTIVE CIRCUIT FOR A BREAKER GAP
CONNEXION D'UN CIRCUIT DE COMMUTATION

(30) Priorität: 22.05.2000 DE 10025276
(43) Veröffentlichungstag der Anmeldung: 19.02.2003
(73) Patentinhaber: SIEMENS AKTIENGESELLSCHAFT, 80333 München (DE)
(72) Erfinder: HEIDER, Peter, 92421 Schwandorf (DE); MITLMEIER, Norbert, 92289 Ursensollen (DE); RUNGGALDIER, Diethard, 96135 Stegaurach (DE); SEITZ, Johann, 92224 Amberg (DE); STREICH, Bernhard, 92224 Amberg (DE)
(86) Internationale Anmeldenummer: PCT/DE2001/001761
(87) Internationale Veröffentlichungsnummer: WO 2001/091149

(56) Entgegenhaltungen:
- US-A- 4 298 810
- US-A- 4 777 479

## Beschreibung

Die vorliegende Erfindung betrifft eine Beschaltung für eine Schaltstrecke, mittels derer eine Lastspannung an eine Last anschaltbar ist, wobei eine Spannungserfassungsschaltung über einen ersten Erfassungswiderstand mit einem eingangsseitigen Erfassungspunkt und über einen zweiten Erfassungswiderstand mit einem ausgangsseitigen Erfassungspunkt der Schaltstrecke galvanisch permanent verbunden ist.

Eine derartige Beschaltung ist z. B. aus der US-A-4 298 810 bekannt.

Aus der US-A-4 777 479 ist ebenfalls eine Beschaltung für eine Schaltstrecke, mittels derer eine Lastspannung an eine Last anschaltbar ist, bekannt. Bei dieser Beschaltung ist eine Spannungserfassungsschaltung über Spannungsteilerwiderstände mit einem eingangsseitigen und direkt mit einem ausgangsseitigen Erfassungspunkt der Schaltstrecke galvanisch permanent verbunden ist.

Die Beschaltungen des Standes der Technik werden beispielsweise bei Schützen zur Erfassung einer beim Ausschalten des Schützes auftretenden Lichtbogenspannung eingesetzt.

Die Aufgabe der vorliegenden Erfindung besteht darin, eine Beschaltung für eine Schaltstrecke zu schaffen, die kostengünstig realisierbar ist, bei der keine Gefahr für Personen und nachgeordnete Schaltungen besteht und bei der die Spannungserfassung zuverlässig und genau erfolgt.

Die Aufgabe wird dadurch gelöst, dass die Erfassungswiderstände gleiche Widerstandswerte aufweisen, die über einem Megaohm liegen.

Wenn die Spannungserfassungsschaltung als Operationsverstärker ausgebildet ist, ergibt sich eine hohe Signalgüte.

Wenn je einer der Erfassungswiderstände mit einem invertierenden bzw. einem nicht invertierenden Signaleingang des Operationsverstärkers verbunden ist und die Signaleingänge über Beschaltungswiderstände mit einer Referenzspannung bzw. einem Signalausgang des Operationsverstärkers verbunden sind, ist das ausgegebene, die erfasste Spannung repräsentierende Signal besonders stabil.

Wenn dem Operationsverstärker eine Versorgungsspannung zugeführt ist und die Referenzspannung die Hälfte der Versorgungsspannung ist, ergibt sich - insbesondere wenn die Lastspannung eine Wechselspannung ist - ein besonders großer Erfassungsbereich.

Wenn der invertierende Signaleingang über eine erste Diodenschaltung mit der Referenzspannung verbunden ist und/oder dem mit dem nicht invertierenden Signaleingang verbundenen Beschaltungswiderstand eine zweite Diodenschaltung parallel geschaltet ist, ist das von der Spannungserfassungsschaltung ausgegebene Signal begrenzt.

Wenn den Beschaltungswiderständen Kondensatoren parallel geschaltet sind, ergibt sich eine bessere Dynamik der Spannungserfassungsschaltung.

Aufgrund der hochohmigen Verbindung der Spannungserfassungsschaltung mit den Erfassungspunkten ist es auch möglich, dass die Spannungserfassungsschaltung mit der Auswerteschaltung nicht nur signaltechnisch, sondern sogar galvanisch permanent verbunden ist.

Wenn die Auswerteschaltung einen mit der Spannungserfassungsschaltung verbundenen Fensterkomparator aufweist, ist die weitere Auswertung des erfassten Spannungssignals besonders einfach.

Die Schaltstrecke kann wahlweise als mechanischer Kontakt (Schütz oder Trennschalter) oder als elektronischer Schalter (Bipolartransistor, IGBT, MOSFET, Thyristor, GTO usw.) ausgebildet sein.

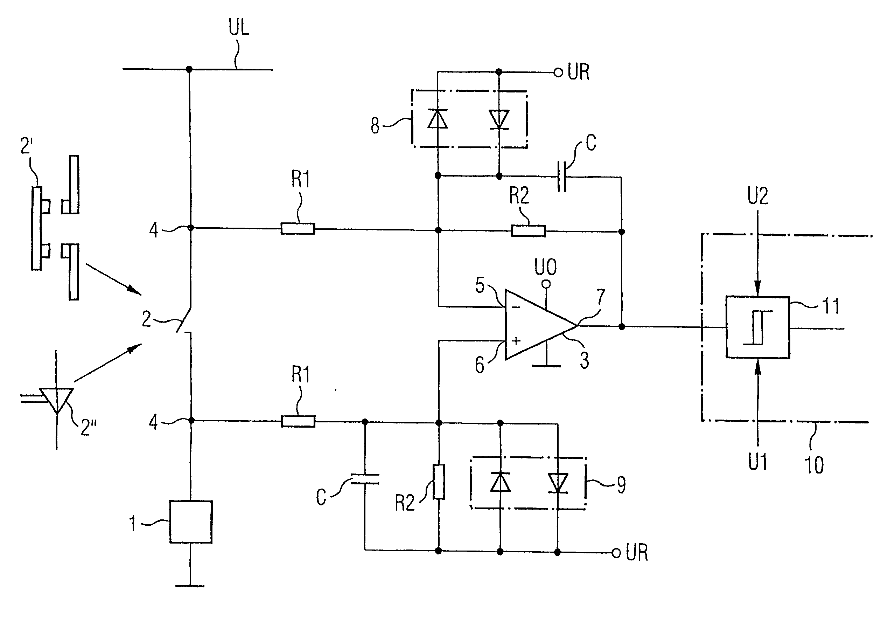

Weitere Vorteile und Einzelheiten ergeben sich aus der nachfolgenden Beschreibung eines Ausführungsbeispiels. Dabei zeigt in Prinzipdarstellung die einzige
- FIG 1: eine Beschaltung für eine Schaltstrecke.

Gemäß FIG 1 ist eine Last 1 über eine Schaltstrecke 2 an eine Lastspannung UL anschaltbar. Die Schaltstrecke 2 kann wahlweise als mechanischer Kontakt 2' oder als elektronischer Schalter 2" ausgebildet sein. Beispiele eines mechanischen Kontakts 2' sind ein Kontakt eines Schützes bzw. ein Kontakt eines Trennschalters, Beispiele eines elektronischen Schalters sind IGBT und GTO-Thyristoren. Die nachfolgend beschriebene Beschaltung ist insbesondere bei mechanischen Kontakten 2' aller Spannungsbereiche und bei elektronischen Schaltern 2" des Hochspannungsbereichs (> 1000 Volt) einzusetzen.

Gemäß FIG 1 ist eine Spannungserfassungsschaltung 3 über Erfassungswiderstände R1 mit Erfassungspunkten 4 verbunden. Je einer der Erfassungspunkte 4 ist dabei bezüglich der Schaltstrecke 2 eingangs- und ausgangsseitig angeordnet. Über die Erfassungswiderstände R1 ist die Spannungserfassungsschaltung 3 mit den Erfassungspunkten 4 hochohmig, aber galvanisch permanent verbunden.

Die Erfassungswiderstände R1 weisen Widerstandswerte auf, die typisch im Bereich oberhalb 1 Megaohm liegen, z. B. bei 3 bis 10 Megaohm. Vorzugsweise weisen sie gleiche Widerstandswerte auf.

Die Spannungserfassungsschaltung 3 ist als Operationsverstärker 3 ausgebildet. Sie weist einen invertierenden Signaleingang 5, einen nichtinvertierenden Signaleingang 6 und einen Signalausgang 7 auf. Dem Operationsverstärker 3 ist eine Versorgungsspannung U0 zugeführt.

Ersichtlich sind die Signaleingänge 5, 6 mit den Erfassungspunkten 4 über die Erfassungswiderstände R1 verbunden. Der invertierende Signaleingang 5 ist ferner über eine Parallelschaltung, die aus einem Beschaltungswiderstand R2 und einem Kondensator C besteht, mit dem Signalausgang 7 verbunden. Der nichtinvertierende Signaleingang 6 ist über eine weitere Parallelschaltung, die ebenfalls aus einem Beschaltungswiderstand R2 und einem Kondensator C besteht, mit einer Referenzspannung UR verbunden.

Die Referenzspannung UR ist prinzipiell beliebig wählbar. Vorzugsweise aber beträgt sie die Hälfte der Versorgungsspannung U0.

Die Beschaltungswiderstände R2 sind erheblich kleiner als die Erfassungswiderstände R1. Ihre Widerstandswerte sind typisch im Bereich < 10 Kiloohm, z. B. 1 bis 5 Kiloohm. Vorzugsweise weisen sie - ebenso wie die Erfassungswiderstände R1 - den gleichen Widerstandswert auf.

Die Kondensatoren C weisen vorzugsweise eine relativ kleine Kapazität auf, z. B. 10-470 nF.

Gemäß FIG 1 ist der invertierende Signaleingang 5 über eine erste Diodenschaltung 8 mit der Referenzspannung UR verbunden. Ferner ist dem Beschaltungswiderstand R2, der mit dem nichtinvertierenden Signaleingang 6 verbunden ist, eine zweite Diodenschaltung 9 parallelgeschaltet. Die Diodenschaltungen 8, 9 weisen je zwei einander antiparallel geschaltete Dioden auf. Vorzugsweise sind die Diodenschaltungen 8, 9 gleich zueinander ausgebildet.

Aufgrund der Beschaltung des Operationsverstärkers 3 liegt bei geschlossener Schaltstrecke 2 am Signalausgang 7 des Operationsverstärkers 3 die Referenzspannung UR an. Wird die Schaltstrecke 2 hingegen geöffnet, fällt über ihr die Lastspannung UL bzw. gegebenenfalls eine Lichtbogenspannung ab. Dadurch verschiebt sich das vom Signalausgang 7 abgegebene Signal nach oben oder unten.

Der Signalausgang 7 des Operationsverstärkers 3 ist mit einer Auswerteschaltung 10 signaltechnisch, im vorliegenden Fall sogar galvanisch permanent, verbunden. Die Auswerteschaltung 10 weist zumindest einen Fensterkomparator 11 auf, dem Vergleichsspannungen U1, U2 zugeführt werden. Die beiden Vergleichsspannungen U1, U2 liegen geringfügig oberhalb bzw. unterhalb der Referenzspannung UR. Der Fensterkomparator 11 liefert ein positives Ausgangssignal, wenn die am Signalausgang 7 des Operationsverstärkers 3 abgegebene Spannung innerhalb des durch die Vergleichsspannungen U1, U2 definierten Spannungsfensters liegt. Ansonsten liefert er ein Nullsignal.

Mittels der erfindungsgemäßen Beschaltung ist auf einfache, kostengünstige und sichere Weise die über der Schaltstrecke 2 abfallende Spannung erfassbar. Die in der Beschaltung auftretenden Verlustleistung ist dabei völlig vernachlässigbar.

## Patentansprüche

1. Beschaltung für eine Schaltstrecke (2), mittels derer eine Lastspannung (UL) an eine Last (1) anschaltbar ist, wobei eine Spannungserfassungsschaltung (3) über einen ersten Erfassungswiderstand (R1) mit einem eingangsseitigen Erfassungspunkt (4) und über einen zweiten Erfassungswiderstand (R1) mit einem ausgangsseitigen Erfassungspunkt (4) der Schaltstrecke (2) galvanisch permanent verbunden ist,
**dadurch gekennzeichnet,**
**dass** die Erfassungswiderstände (R1) gleiche Widerstandswerte aufweisen, die über 1 Megaohm liegen.

2. Beschaltung nach Anspruch 1,
**dadurch gekennzeichnet,**
**dass** die Spannungserfassungsschaltung (3) als Operationsverstärker (3) ausgebildet ist.

3. Beschaltung nach Anspruch 2,
**dadurch gekennzeichnet,**
**dass** je einer der Erfassungswiderstände (R1) mit einem invertierenden bzw. einem nicht invertierenden Signaleingang (5, 6) des Operationsverstärkers (3) verbunden ist und dass die Signaleingänge (5, 6) über Beschaltungswiderstände (R2) mit einer Referenzspannung (UR) bzw. einem Signalausgang (7) des Operationsverstärkers (3) verbunden sind.

4. Beschaltung nach Anspruch 3,
**dadurch gekennzeichnet,**
**dass** die Beschaltungswiderstände (R2) gleiche Widerstandswerte aufweisen.

5. Beschaltung nach Anspruch 3 oder 4,
**dadurch gekennzeichnet,**
**dass** dem Operationsverstärker (3) eine Versorgungsspannung (U0) zugeführt ist und dass die Referenzspannung (UR) die Hälfte der Versorgungsspannung (U0) ist.

6. Beschaltung nach Anspruch 3, 4 oder 5,
**dadurch gekennzeichnet,**
**dass** der invertierende Signaleingang (5) über eine erste Diodenschaltung (8) mit der Referenzspannung (UR) verbunden ist.

7. Beschaltung nach einem der Ansprüche 3 bis 6,
**dadurch gekennzeichnet,**
**dass** dem mit dem nicht invertierenden Signaleingang (6) verbundenen Beschaltungswiderstand (R2) eine zweite Diodenschaltung (9) parallel geschaltet ist.

8. Beschaltung nach einem der Ansprüche 3 bis 7,
**dadurch gekennzeichnet,**
**dass** den Beschaltungswiderständen (R2) Kondensatoren (C) parallel geschaltet sind.

9. Beschaltung nach einem der Ansprüche 1 bis 8,
**dadurch gekennzeichnet,**
**dass** die Spannungserfassungsschaltung (3) mit einer Auswerteschaltung (10) signaltechnisch verbunden ist.

10. Beschaltung nach Anspruch 9,
**dadurch gekennzeichnet,**
**dass** die Spannungserfassungsschaltung (3) mit der Auswerteschaltung (10) galvanisch permanent verbunden ist.

11. Beschaltung nach Anspruch 9 oder 10,
**dadurch gekennzeichnet,**
**dass** die Auswerteschaltung (10) einen mit der Spannungserfassungsschaltung (3) verbundenen Fensterkomparator (11) aufweist.

12. Beschaltung nach einem der Ansprüche 1 bis 11,
**dadurch gekennzeichnet,**
**dass** die Schaltstrecke (2) als mechanischer Kontakt (2') ausgebildet ist.

13. Beschaltung nach einem der Ansprüche 1 bis 11,
**dadurch gekennzeichnet,**
**dass** die Schaltstrecke (2) als elektronischer Schalter (2") ausgebildet ist.

## Claims

1. A circuit for a circuit-breaker gap (2), by means of which a load voltage (UL) can be applied to a load (1), with a voltage detection circuit (3) being conductively permanently connected via a first detection resistor (R1) to an input-side detection point (4) and via a second detection resistor (R1) to an output-side detection point (4) of the circuit-breaker gap (2),
**characterized in**
**that** the detection resistors (R1) have the same resistance values, which are greater than 1 megaohm.

2. The circuit as claimed in Claim 1,
**characterized in**
**that** voltage detection circuit (3) is in the form of an operational amplifier (3).

3. The circuit as claimed in Claim 2,
**characterized in**
**that** in each case one of the detection resistors (R1) is connected to an inverting signal input (5) or to a non-inverting signal input (6) of the operational amplifier (3), and in that the signal inputs (5,6) are connected via circuit resistors (R2) to a reference voltage (UR) and, respectively, to a signal output (7) of the operational amplifier (3).

4. The circuit as claimed in Claim 3,
**characterized in**
**that** the circuit resistors (R2) have the same resistance value.

5. The circuit as claimed in Claims 3 or 4,
**characterized in that** the operational amplifier (3) is supplied with a supply voltage (UO), and that the reference voltage (UR) is half the supply voltage (UO).

6. The circuit as claimed in Claims 3, 4 or 5,
**characterized in**
**that** the inverting signal input (5) is connected via a first diode circuit (8) to the reference voltage (UR).

7. The circuit as claimed in Claims 3 to 6,
**characterized in**
**that** the circuit resistor (R2) which is connected to the non-inverting signal input (6) is connected in parallel with a second diode circuit (9).

8. The circuit as claimed in one of Claims 3 to 7,
**characterized in**
**that** the circuit resistors (R2) are connected in parallel with capacitors (C).

9. The circuit as claimed in one of Claims 1 to 8,
**characterized in**
**that** the voltage detection circuit (3) is connected, for signaling purposes, to an evaluation circuit (10).

10. The circuit as claimed in Claim 9,
**characterized in**
**that** the voltage detection circuit (3) is conductively permanently connected to the evaluation circuit (10).

11. The circuit as claimed in Claim 9 or 10,
**characterized in**
**that** the evaluation circuit (10) has a window comparator (11) which is connected to the voltage detection circuit (3).

12. The circuit as claimed in one of Claims 1 to 11,
**characterized in**
**that** the circuit-breaker gap (2) is in the form of a mechanical contact (2').

13. The circuit as claimed in one of Claims 1 to 11,
**characterized in**
**that** the circuit-breaker gap (2) is in the form of an electronic switch (2").

## Revendications

1. Connexion d'une section (2) de coupure, au moyen duquel une tension (UL) de charge peut être appliquée sur une charge (1), un premier circuit (3) de détection de tension étant relié galvaniquement en permanence par une première résistance (R1) de détection à un point (4) de détection du côté de l'entrée et par une deuxième résistance (R1) de détection à un point (4) de détection du côté de la sortie de la section (2) de coupure,
**caractérisée en ce que**
les résistances (R1) de détection ont les mêmes valeurs qui sont supérieures à 1 mégaohm.

2. Connexion suivant la revendication 1,
**caractérisée en ce que**
le circuit (3) de détection de la tension est constitué en amplificateur (3) opérationnel.

3. Connexion suivant la revendication 2,
**caractérisée en ce que**
respectivement l'une des résistances (R1) de détection est reliée à une entrée (5, 6) du signal inverseuse ou non inverseuse de l'amplificateur (3) opérationnel et **en ce que** les entrées (5, 6) du signal sont reliées par des résistances (R2) de connexion à une tension (UR) de référence ou à une sortie (7) du signal de l'amplificateur (3) opérationnel.

4. Connexion suivant la revendication 3,
**caractérisée en ce que**
les résistances (R2) de connexion ont les mêmes valeurs.

5. Connexion suivant la revendication 3 ou 4,
**caractérisée en ce que**
il est appliqué à l'amplificateur (3) opérationnel une tension (UO) d'alimentation et **en ce que** la tension (UR) de référence est la moitié de la tension (UO) d'alimentation.

6. Connexion suivant la revendication 3, 4 ou 5,
**caractérisée en ce que**
l'entrée (5) inverseuse du signal est reliée à la tension (UR) de référence par un premier circuit (8) à diodes.

7. Connexion suivant l'une des revendications 3 à 6,
**caractérisée en ce que**
un deuxième circuit (9) à diodes est monté en parallèle avec la résistance (R2) de connexion reliée à l'entrée (6) non inverseuse du signal.

8. Connexion suivant l'une des revendications 3 à 7,
**caractérisée en ce que**
des condensateurs (C) sont montés en parallèle aux résistances (R2) de connexion.

9. Connexion suivant l'une des revendications 1 à 8,
**caractérisée en ce que**
le circuit (3) de détection de la tension est relié du point de vue de la technique du signal à un circuit (10) d'exploitation.

10. Connexion suivant la revendication 9,
**caractérisée en ce que**
le circuit (3) de détection de la tension est relié en permanence du point de vue galvanique au circuit (10) d'exploitation.

11. Connexion suivant la revendication 9 ou 10,
**caractérisée en ce que**
le circuit (10) d'exploitation a un comparateur (11) à fenêtre relié au circuit (3) de détection de la tension.

12. Connexion suivant l'une des revendications 1 à 11,
**caractérisée en ce que**
la section (2) de coupure est constituée sous la forme d'un contact (2') mécanique.

13. Connexion suivant l'une des revendications 1 à 11,
**caractérisée en ce que**
la section (2) de coupure est réalisée sous la forme d'un commutateur (2") électronique.
